Europäisches Patentamt

European Patent Office

Office européen des brevets

(19)

(11) Publication number : **0 480 880 A1**

## (12) EUROPEAN PATENT APPLICATION

(21) Application number : **91830208.4**

(22) Date of filing : **20.05.91**

(51) Int. Cl.⁵ : **H05K 5/02**

(30) Priority : **05.10.90 IT 58590 U**

(43) Date of publication of application :
**15.04.92 Bulletin 92/16**

(84) Designated Contracting States :
**AT BE CH DE DK ES FR GB GR LI LU NL SE**

(71) Applicant : **GAPOSA S.r.l.**
**Via Pompeiana, 220**
**I-63023 Fermo (AP) (IT)**

(72) Inventor : **Gasparrini, Cesare**
**Via Zeppilli, 28**
**I-63023 Fermo (AP) (IT)**

(74) Representative : **Baldi, Claudio**
**Piazza Ghislieri, 3**
**I-60035 Jesi (Ancona) (IT)**

(54) **Protective box for push-button control panels in general.**

(57)    This invention concerns a protective box for push button control panels, with a flap for access to the inside, made up of a latch which is activated directly by turning the key in the lock.

FIG. 2

This patent application concerns a protective box for push button type or other types of control panels, whether they be electric, mechanical, or hydraulic, which should not be accessible to everyone but only to authorised persons.

At the present time, electric control selectors are available on the market, which are contained within a metallic unbreakable box, equipped at the front with a lock in which to insert the key, which, when turned in one direction, generates the opening of a flap, with electric lock or the raising of a motorised shutter, and in the other direction, generates their closing action.

If it is required to protect any type of switch already installed, without having to replace it with special switches equipped with control key, normally use is made of small boxes designed to be firmly fixed to the wall, so that the switch to be protected remains enclosed inside.

Said protective boxes, in spite of the variety of models produced, all the the same basic approach to construction, characterised by the presence of a frontal flap for access to the inside, on the bottom of which the button which requires protection is located.

Said flap is equipped with a safety lock, in such a way that only the person in possession of the key can gain access to the control button enclosed within the box.

The aim of the instant invention is to propose a new type of protective box for push button control panels in general, as an alternative to those currently available; compared to the latter, the model according to the invention is considerably less complicated and more economical to produce, as well as being more practical and easy to use.

The main characteristic of the model in question lies in the fact that the closing flap of the protective box has no hinge pins, in that it is not of the standard rotating or swing type, but of the latch type; a further characteristic of the model according to the invention lies in the fact that the movement of said latch requires no specific intervention on the part of the operator, in that this is obtained automatically by turning the key with which the box is equipped for opening and closing.

In other words, the box according to the invention does not require the use of an actual lock designed to hook and block the flap to the support frame, as is the case with all other box models produced to date.

Rotation of the flap, in fact, both in opening and closing the box currently takes place by the driving pressure exercised by the operator, who is therefore required to perform two distinct operations : one being to open or close the lock by means of the key, the other being to tilt the flap.

In the model in question, when the key is turned within the lock, this causes the rotation at 90° on a vertical plane of a balance terminating in a pin, sliding within the horizontal slit of a latch which opens and closes the window providing access to the inside of the box, where the push button control to be protected, is located. Preferably, said box is manufactured from moulding in light alloys or highly resistant plastic material; the aforementioned latch is then reinforced with a metallic sheet positioned between two plastic plates, so as to provide it with a multi-layered, shockproof, structure. For further clarity of explanation, the description of the invention continues with reference to the attached drawings, reproduced for illustrative and not limitative purposes, wherein;

- Fig.1 is the front view of the protective box according to the invention, with the latch down and closed;
- Fig. 2 is the section of Fig.1 in II-II plane;
- Fig.3 is the section of Fig.1 in III-III plane;
- Fig.4 is a rear view of the protective box according to the invention with the latch down and closed;
- Fig.5 is the identical section to Fig.2, in which, however, the push button enclosed within the protective box has also been schematically reproduced.

With reference to the aforementioned figures, the protective box according to the invention, consists of a box frame (1), moulded in a single piece preferably of plastic material, to which a closing cover (2) is previously applied and welded, which has a large window (2a) at the bottom and an internally hollow projection (2b) at the top, intended to lodge the lock (3) in which to insert the key.

The end of a balance (4) is internally screwed to said lock (3), terminating at its other end in a pin (4a) precisely nested and free to slide within a horizontal slit (5a), located on the opening and closing latch of said window (2a).

Said latch (5), is positioned between the frame (1) and the cover (2), which both have internal flanges and lateral counter-flanges, intended to bound two opposing vertical guides to contain the latch (5).

Attention should be paid to the fact that the latch (5), has a sandwich structure, made up of two identical external plastic plates (5a) and an intermediate metallic, shockproof sheet (5b).

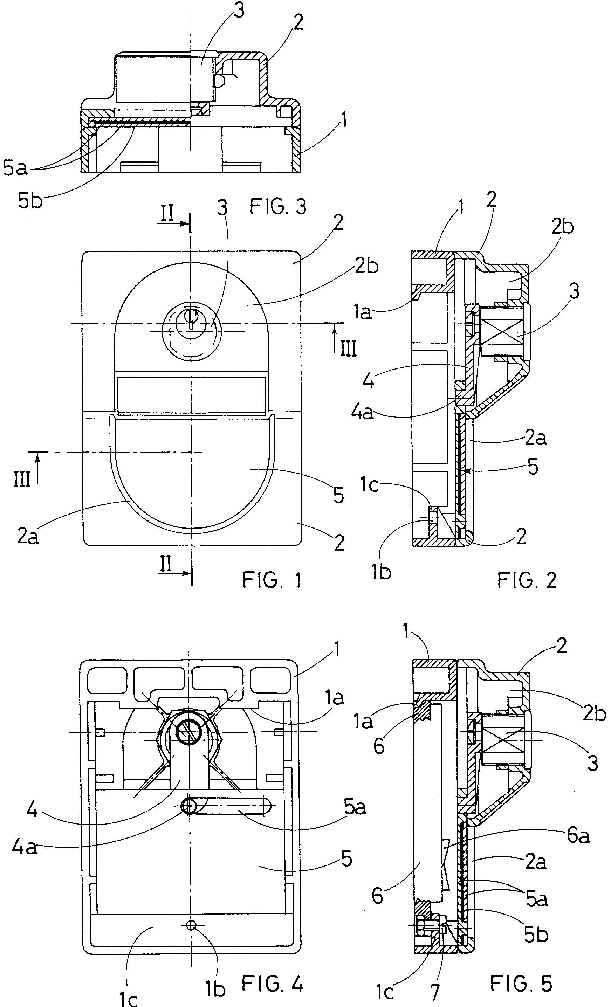

In Fig.2, the number 5c indicates the centering button present on one of the external plastic plates (5a), which is inserted precisely within a corresponding hole both on the intermediate metallic sheet (5b) and on the other external plastic plate.

On the back of the frame (1), at the top, there is a transversal step (1a) to be recessed behind the top edge of the support plate (6) of the push button (6a) to be protected, as illustrated in Fig.5, so as to obstruct the removal of the protective box which is hooked to said plate (6) also at the bottom by means of a common fixing screw (7), which is inserted in a hole (1b) on an internal transversal section (1c), provided for the purpose on the low wall of the frame (1).

This screw (7), therefore is located in the same area where the push button is located, closed and protected by the latch (5), therefore disassembling and assembly of the box, according to the invention, can only be effected by persons in possession of the key, in as much as access to the screw (7), is only possible when the latch (5) is up and open.

## Claims

1) Protective box for push button control panels in general characterised by the fact that it comprises a box frame (1), closed at the front by a cover (2) with a large window (2a) at the bottom, and an internally hollow projection (2b) at the top, to lodge the lock (3) where the key is to be inserted, to which the end of a balance (4) is internally screwed, this terminating at its other end in a pin (4a), lodged precisely and sliding within a horizontal slit (5a) on the latch (5), positioned between the frame (1) and the cover (2); it being provided that the frame (1) have at the back and at the top a transversal step (1a), intended to be hooked behind the top edge of the support plate (6) of the push button panel to be protected, and at the bottom a transversal section (1c) with a central hole (1b), where a screw (7) to be screwed to the aforementioned support plate, is located;

2) Protective box for push button control panels in general, according to claim 1), and characterised by the fact that the latch (5) is composed of two identical external plastic plates (5a) and a metallic intermediate shockproof sheet (5b).

3 2

5a

5b

FIG. 3

1

II 3 2

2b

1a

4

4a

III

III

5

2a

II

2

FIG. 1

1 2

2b

3

4

4a

2a

5

1c

2

1b

FIG. 2

1

1a

4

4a

5a

5

1c

1b

FIG. 4

1

1a

6

6

2

2b

3

6a

2a

5a

5b

1c

7

FIG. 5

4

**European Patent Office**

## EUROPEAN SEARCH REPORT

Application Number

EP 91 83 0208

### DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | WO-A-8 801 675 (SECURE TECHNOLOGIES) * page 1, lines 3-9; page 4, lines 6-26; page 3, lines 14-27; page 6, lines 6-8; page 7, lines 1-3; figures 1-4,9-12 * | 1 | H 05 K 5/02 |
| A | DE-A-3 426 131 (KATHREIN-WERKE) * page 10, lines 13-26; figures 1,2 * | 1 | |

**TECHNICAL FIELDS SEARCHED (Int. Cl.5)**

H 05 K 5/00
E 05 B 55/00
E 05 B 57/00

The present search report has been drawn up for all claims

| Place of search | Date of completion of the search | Examiner |
|---|---|---|
| BERLIN | 17-01-1992 | ALEXATOS G |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)